# EUROPEAN PATENT APPLICATION

(11) **EP 3 297 160 A1**
(43) Date of publication of application: **21.03.2018**
(21) Application number: 16188789.8
(22) Date of filing: 14.09.2016
(51) Int. Cl.: H03F 3/21, G01R 31/28, G06F 17/50, H04B 17/00

(54) **METHOD FOR CALIBRATING AN INPUT CIRCUIT AND SYSTEM FOR CALIBRATING AN INPUT CIRCUIT**

(71) Applicant: Rohde & Schwarz GmbH & Co. KG, 81671 München (DE)
(72) Inventor: LLOYD, Gareth, 81827 München (DE)
(74) Representative: Isarpatent

(57) **Abstract**

The invention provides a method and a system for calibrating an input circuit (20) of a device (10) under test, the device including an amplifying circuit (30) and a combining circuit (40). The method comprises the steps of: supplying (S01) at least one test signal (to the amplifying circuit; varying (502) at least one test signal characteristic of the test signal supplied to the amplifying circuit; detecting (S03), based on an output signal output by the combining circuit, at least one device characteristic of the device as a function of the varied test signal characteristic; determining (S04) at least one optimizing value of the test signal characteristic that optimizes at least one of the detected device characteristics according to at least one preset optimization criterion; and calibrating (S05) the input circuit based on the determined optimizing value of the test signal characteristic.

## Description

### FIELD OF THE INVENTION

The present invention relates to a method for calibrating an input circuit for a device comprising an amplifying circuit and a combining circuit, and to a system for calibrating an input circuit for a device comprising an amplifying circuit and a combining circuit. The invention also relates to a non-volatile storage medium comprising a program code for calibrating an input circuit.

### BACKGROUND OF THE INVENTION

Amplifier apparatuses are used in countless applications. One possible application of an amplifier apparatus is as an active load modulation amplifier, for example in an RFID system.

An amplifier apparatus, in particular a multiple path amplifier apparatus, usually comprises, or consists of, three circuits: first an input circuit, second an amplifying circuit, and third a combining circuit. The input circuit may also be called an input network or a splitter. The amplifying circuit usually comprises transistors and fitted matching networks. The combining circuit may also be called an output network. Maximum bandwidth performance is achieved when all three of those circuits are ideal, i.e. without deviations from their respective schematics.

In the prior art, it is endeavored to create said three circuits designed as close as possible to a standard, fixed 0 degree, 90 degrees or 180 degrees phase difference, depending on the amplifier circuit architecture (e.g. Doherty, anti-phase, balanced, spatially combined). The circuits are then connected to form the amplifier apparatus.

The Doherty amplifier apparatus, since its invention in the 1930s, has enjoyed something of a renaissance in recent years in transmitter frontend hardware. Its persistent presence in the literature, including conference proceedings and patent databases, are testament to its elegance and flexibility. A Doherty amplifier apparatus is described e.g. in US 2 210 028 A.

It is preferred, to achieve an operation as originally intended in US 2 210 028 A, that two broad conditions are fulfilled for amplifying circuits and combining circuits: the output current sourced by the auxiliary amplifying circuit must have a specific characteristic, in particular discontinuous relative to a drive signal, and the combining circuit ("impedance inverter") must be 90 degrees length. In practice, often neither of the two conditions can be completely met. As a result, a load modulation process in which the amplifier device is used may not be purely real.

### SUMMARY OF THE INVENTION

It is one of the objects of the present invention to provide a method, and a system, for providing an improved input circuit with improved bandwidth performance.

The invention provides a method with the features of claim 1, a non-volatile storage medium with the features of claim 11, and a system with the features of claim 12.

According to a first aspect of the invention, a method for calibrating an input circuit for an amplifier device comprising an amplifying circuit and a combining circuit is provided.

The method comprises the steps of: supplying at least one test signal to the amplifying circuit; wherein, as a result of the supplying of the test signal to the amplifying circuit, an output signal is output by the combining circuit; varying at least one test signal characteristic of the test signal supplied to the amplifying circuit; detecting, based on the output signal, at least one device characteristic of the device as a function of the varied test signal characteristic; determining at least one optimizing value of the test signal characteristic that optimizes at least one of the detected device characteristics according to at least one optimization criterion; and calibrating the input circuit based on the determined optimizing value of the test signal characteristic.

The calibrating may be performed in particular in order to improve the linearity of an amplifier apparatus created by connecting the calibrated input circuit with, or to, the device under test.

In the wording used in the following, the term "device" may be understood as a part of an amplifier apparatus, the device comprising, or consisting of, an amplifying circuit and a combining circuit. The amplifier apparatus may comprise, or consist of, said device and an input circuit coupled to said device.

According to a second aspect of the invention, a non-volatile storage medium comprising a program code for calibrating an input circuit is provided. The non-volatile storage medium comprises a program code executable by a processor, the program code being adapted to perform, when executed, a method according to the first aspect of the present invention. The non-volatile storage medium may be a CD-ROM, a flash drive, a floppy disk, and SD card and so on.

According to a third aspect of the invention, a system for calibrating an input circuit for an amplifier device comprising an amplifying circuit and a combining circuit is provided.

The system comprises: a signal generator unit, a signal analyzing unit, and a calculating unit. The signal generator unit may be configured to supply at least one test signal to the amplifying circuit, and to vary at least one test signal characteristic of the test signal supplied to the amplifying circuit. The signal analyzing unit may be configured to detect, from an output signal of the combining circuit, at least one device characteristic of the device as a function of the at least one varied test signal characteristic. The calculating unit may be configured to determine at least one optimizing value of the test signal characteristic that optimizes at least one of the device characteristics according to at least one preset rule and to produce a result signal indicating the determined at least one optimizing value of the signal characteristic.

One principle idea of the present invention is to achieve performance improvements by optimizing the input (or splitter) circuit to accommodate dispersion in the amplifying and combining circuits. In this way, effectively a frequency domain equalization may be performed.

To this end, the amplifying circuit and the combining circuit may be prototyped in hardware earlier than the input circuit in the development phase. Those two circuits may then, as described herein, be characterized and their imperfections may be compensated by calibrating the input circuit, during the design and/or during the production of the input circuit.

According to some embodiments, the at least one signal characteristic of the at least one test signal is at least one of a frequency, an absolute amplitude, a differential amplitude and/or a differential phase of the at least one test signal.

According to some embodiments, the at least one device characteristic is at least one of an efficiency, an adjacent channel leakage power ratio, ACLR, an output power, a linearity and/or a peak envelope power of the device under test.

According to some embodiments, the at least one criterion is based on the at least one test signal characteristic and/or the at least one device characteristic. The criterion may be a preset criterion. Alternatively or additionally the criterion may be set, or adjusted, by a user input or according to a program code.

According to some embodiments, the at least one test signal is provided by a signal generating unit and the device characteristic is detected by a signal analyzing unit. The method may further comprise the method step of synchronizing the signal generating unit and the signal analyzing unit. In this way, the detecting of the at least one device characteristic may be improved.

According to some embodiments, the amplifying circuit and/or the combining circuit is connected to an internal and/or an external power source. The method may further comprise the method step of synchronizing the internal and/or external power source with the signal generating unit and/or with the signal analyzing unit.

According to some embodiments, the calibrating of the input circuit comprises at least one of: controlling a calibrating unit to produce the input circuit based on the determined optimizing values, adapting properties of an input circuit based on the determined optimizing values, creating a blueprint or schematics data for a calibrating unit based on the determined optimizing values, based on which the calibrating unit is able to produce the input circuit, and/or choosing one out of a set of pre-produced input circuits based on the determined optimizing values. Accordingly, depending on e.g. the given architecture of the amplifying circuit and the combining circuit and/or on the intended basic architecture of the input circuit, an optimal method for calibrating the input circuit may be chosen. In some embodiments, the calibrating of the input circuit may also be called an adjusting, a providing or a producing of the input circuit.

According to some embodiments, the method according to the first aspect of the invention comprises the method step of connecting the calibrated input circuit to the device under test, to create an amplifier apparatus, wherein the device under test comprises, or consists of, the amplifying circuit and the combining circuit. A method including this method step may also be designated as a method for providing, or producing, an amplifier apparatus.

According to some embodiments of the method for providing, or producing, the amplifier apparatus, the amplifier apparatus is configured with a Doherty amplifier architecture, a Balanced amplifier architecture, an Anti-phase amplifier architecture and/or a Spatially Combined amplifier architecture. It should be noted that these amplifier architectures are not mutually exclusive, e.g. a Doherty amplifier may be constructed using one or more anti-phase amplifiers, multiple anti-phase amplifiers may be balanced and so on.
Fig. 7 to Fig. 10 show schematic block diagrams of amplifier architectures.
Fig. 7 shows an amplifier apparatus with an anti-phase, or push-pull, amplifier architecture, comprising a Balun splitter 1-20 as an input circuit, an amplifying circuit 1-30, and a Balun combiner 1-40 as a combining circuit.
Fig. 8 shows an amplifier apparatus with a Balanced amplifier architecture, comprising a quadrature splitter 2-20 as an input circuit, an amplifying circuit 2-30, and a quadrature combiner 2-40 as a combining circuit.
Fig. 9 shows an amplifier apparatus with a Doherty amplifier architecture, comprising a Doherty splitter 3-20 as an input circuit, an amplifying circuit 3-30, and a Doherty combiner 3-40 as a combining circuit.
Fig. 10 shows an amplifier apparatus with a Spatially Combined amplifier architecture, comprising an in-phase splitter 4-20 as an input circuit, an amplifying circuit 4-30, and a spatial combiner 4-40 as a combining circuit.

According to some embodiments, the amplifier apparatus is configured as an active load modulation amplifier apparatus.

According to some embodiments of the third aspect of the present invention, the system may comprise a power source connectable or connected to the amplifying circuit and/or to the combining circuit. The power source may be synchronized with the signal generator unit and/or with the signal analyzing unit.

According to some embodiments, an attenuator is coupled between the combining circuit and the signal analyzing unit.

### BRIEF DESCRIPTION OF THE DRAWINGS

The invention will be explained in greater detail with reference to exemplary embodiments depicted in the drawings as appended.

The accompanying drawings are included to provide a further understanding of the present invention and are incorporated in and constitute a part of this specification. The drawings illustrate the embodiments of the present invention and together with the description serve to explain the principles of the invention. Other embodiments of the present invention and many of the intended advantages of the present invention will be readily appreciated as they become better understood by reference to the following detailed description. The elements of the drawings are not necessarily to scale relative to each other. Like reference numerals designate corresponding similar parts.

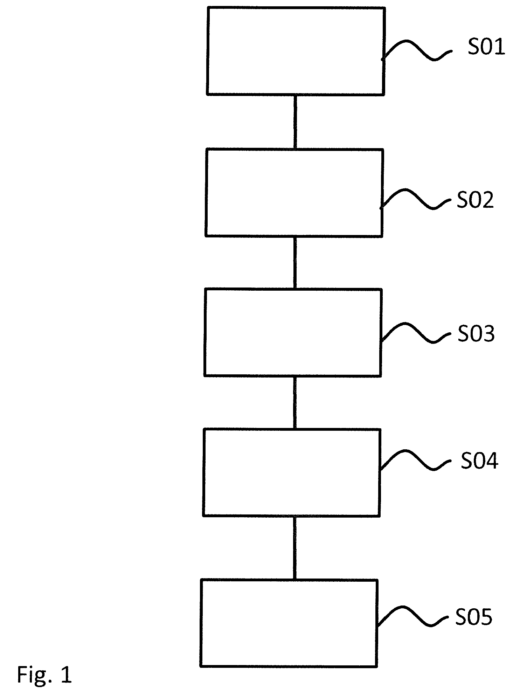

- Fig. 1: shows a schematic flow diagram illustrating a method for calibrating an input circuit for a device under test including an amplifying circuit and a combining circuit according to an embodiment of the first aspect of the invention;

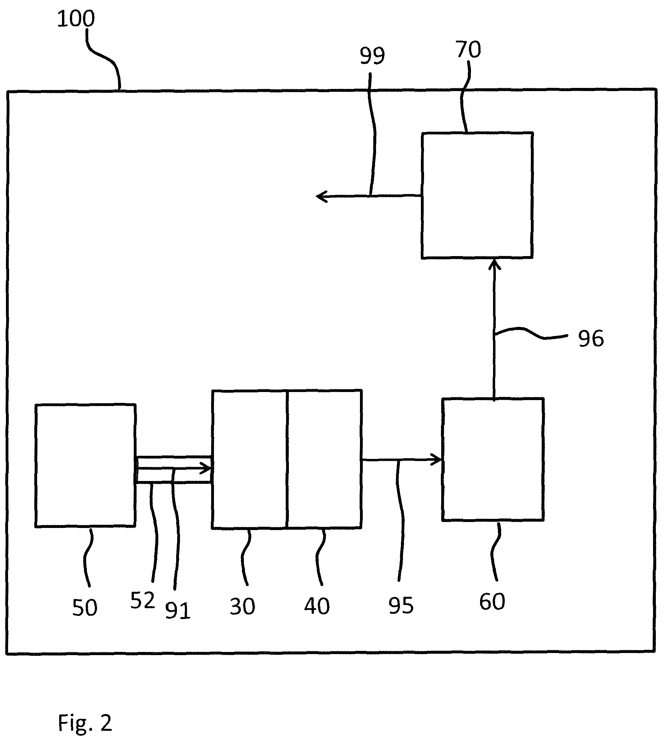

- Fig. 2: shows a schematic block diagram illustrating a system for calibrating an input circuit for a device under test comprising an amplifying circuit and a combining circuit according to an embodiment of the third aspect of the invention;

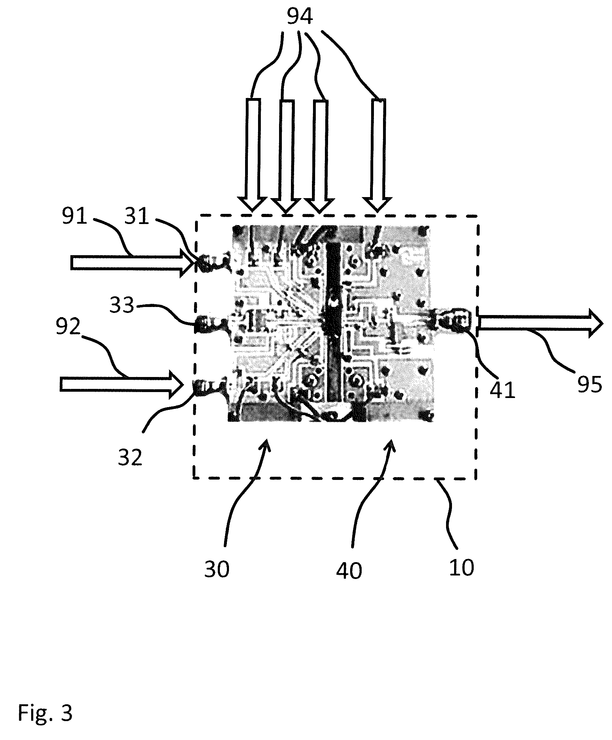

- Fig. 3: shows a schematic illustration of a device under test;

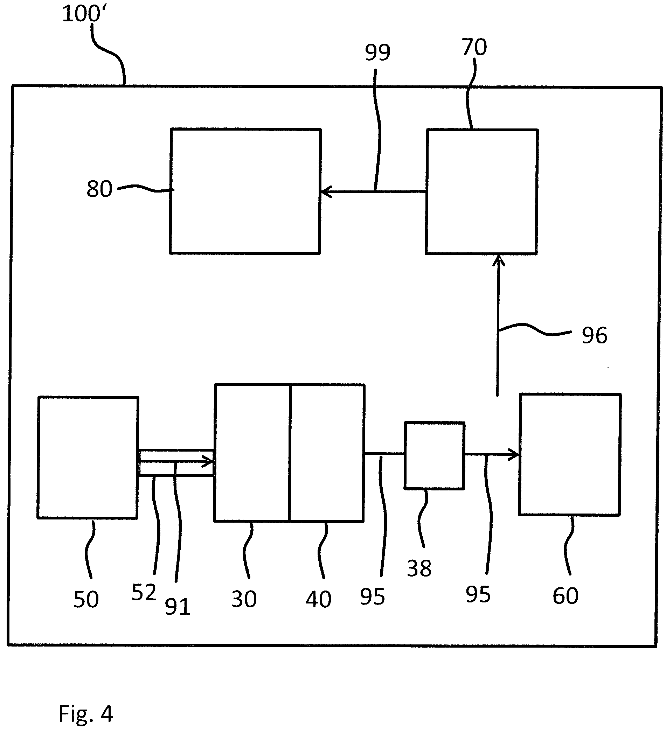

- Fig. 4: shows a schematic block diagram illustrating a system for calibrating an input circuit for a device under test comprising an amplifying circuit and a combining circuit according to another embodiment of the third aspect of the invention;

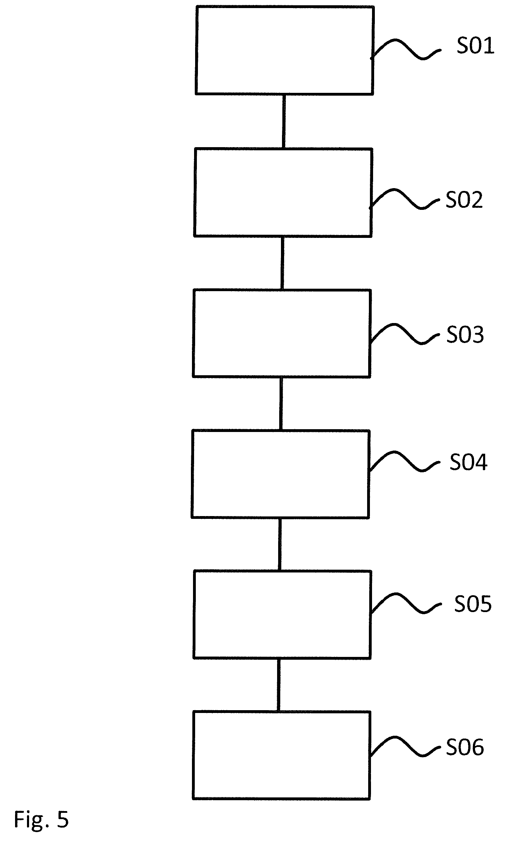

- Fig. 5: shows a schematic flow diagram illustrating a method for calibrating an input circuit for a device under test including an amplifying circuit and a combining circuit according to another embodiment of the first aspect of the invention;

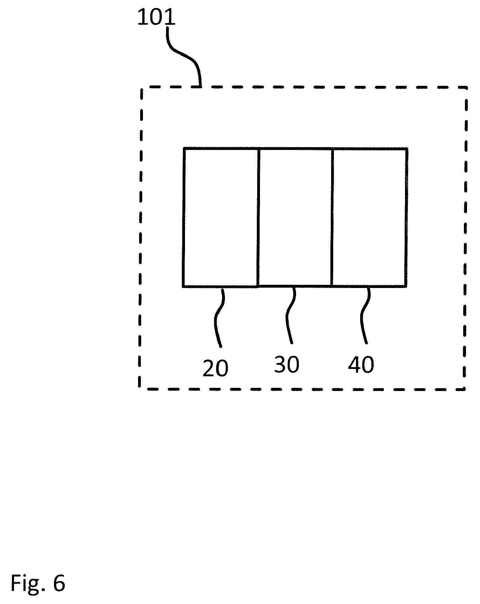

- Fig. 6: shows a schematic block diagram of an amplifier apparatus created by the method of Fig. 5; and

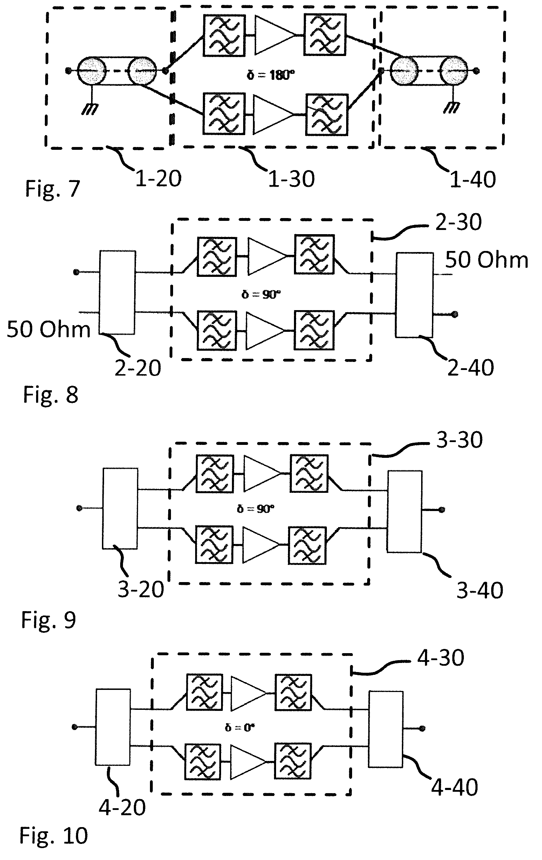

- Fig. 7 to Fig. 10: show schematic block diagrams of amplifier architectures.

In the figures, like reference numerals denote like or functionally like components, unless indicated otherwise.

### DETAILED DESCRIPTION OF THE INVENTION

Although specific embodiments have been illustrated and described herein, it will be appreciated by those of ordinary skill in the art that a variety of alternate and/or equivalent implementations may be substituted for the specific embodiments shown and described without departing from the scope of the present invention. Generally, this application is intended to cover any adaptations or variations of the specific embodiments discussed herein. For example, other amplifier apparatus architectures as the ones described above and in the following may be used or provided. Some or all of the system components may be differently combined.

Fig. 1 shows a schematic flow diagram illustrating a method for calibrating an input circuit for a device under test comprising an amplifying circuit and a combining circuit. In describing the flow diagram of Fig. 1, reference will also be made to Fig. 2 and Fig. 3.

Fig. 2 shows a schematic block diagram illustrating a system 100 for calibrating an input circuit for a device 10 under test comprising an amplifying circuit 30 and a combining circuit 40. The system 100 may be used to perform the method of Fig. 1 and is modifiable or adaptable to all modifications and variations described with respect to the method of Fig. 1 and vice versa.

Fig. 3 shows a schematic illustration of a device 10 under test. In detail, Fig. 3 shows a schematic illustration of an amplifying circuit 30 and a combining circuit 40 forming the device 10 under test. The amplifying circuit 30 is configured with a first input port 31, a second input port 32, and a third input port 33. The amplifying circuit 30 is connected to a combining circuit 40 configured with an output port 41.

Referring to Fig. 1, in a method step S01, at least one test signal 91, 92 is supplied to the device 10 under test, in particular to the amplifying circuit 30 connected to the combining circuit 40. The amplifying circuit 30 and the combining circuit 40 may be removably connected. A method step of connecting the amplifying circuit 30 and the combining circuit 40 may precede the method step S01. Referring to the variant shown in Fig. 3, the at least one test signal 91, 92 is supplied preferably to at least two input ports 31, 32 of the amplifying circuit 30. In particular, a first test signal 91 may be supplied to the first input port 31 of the amplifying circuit 30, and a second test signal 92 may be supplied to the second input port 32 of the amplifying circuit 30.

As also indicated in Fig. 3, the device 10 under test may also be supplied with at least one additional power and/or bias signal 94, e.g. from an external power source and so on. For instance, the external power source may be the "R&S®HMC Power Supply" by Rohde&Schwarz. The supplying S01 of the at least one test signal 91, 92 may be performed during, before and/or after the supplying of the at least one additional power and/or bias signal 94. In Fig. 3, as an example, four arrows representing additional power and/or bias signals 94 are shown.

The test signals 91, 92 may comprise, or consist of, one or more 3GPP carriers, in particular with baseband offsets ranging from -80 MHz to +80 MHz in increments of 10 MHz. 3GPP is an acronym for "3rd Generation Partnership Project" and is the standardization body behind LTE. 3GPP is addressing IMT-Advanced requirements by standardizing LTE-Advanced as part of its Release 10.

In a method step S02, at least one signal characteristic of the at least one test signal 91, 92 is varied, in particular swept. In other words, said at least one signal characteristic is varied from a first threshold value to a second threshold value, either continuously or in discrete steps of values. More than one signal characteristics of the at least one test signal 91, 92 may be varied, either consecutively or simultaneously. The varying S02 may comprise a method step in which the at least one signal characteristic to be varied is selected from a list of variable signal characteristics.

The at least one signal characteristic of the at least one test signal 91, 92 may be at least one of a frequency, an absolute amplitude, a differential input amplitude and/or a differential input phase.

Referring to Fig. 2, the supplying S01 of the at least one test signal 91, 92 and the varying S02 of the at least one signal characteristic of the at least one test signal 91, 92 may be performed by a signal generator unit 50 of the system 100. The signal generator unit 50 may be an arbitrary waveform generator, AWG, and/or a multi-source signal generator, for example, the "R&S®SMW200A Vector Signal Generator" by Rohde&Schwarz. The signal generator unit 50 may preferably be configured to perform the supplying S01 and the varying S02 in the same way as described in the foregoing and in the following with respect to the method according to the first aspect of the invention, in particular with respect to Fig. 1.

Before the supplying S01 of the at least one test signal 91, 92, a calibrating of the signal generator unit 50 and/or of cables 52 connecting the signal generator unit 50 to the amplifying circuit 30 may be performed, for instance using a calibration signal. The calibration signal may comprise three 3GPP carriers, each separated by the same frequency interval. For example, the frequency interval may be 80 MHz so that the calibration signal occupies 160 MHz total. In particular, the cables 52 may be calibrated for amplitude, phase and time delay.

The varying S02 of more than one signal characteristic may be performed in a nested way. Preferably, variations of signal characteristics that may be varied more quickly are nested within variations of signal characteristics that may be varied more slowly. In other words, a nesting hierarchy, from a first (outermost) level to an n-th (innermost) level, the first level varying most slowly and the n-th level varying most quickly, of the variations of more than one signal characteristic may be determined, wherein n may be 2 or larger. The nesting hierarchy may be set or determined, in part or exclusively, based on how quickly the respective signal characteristic may be varied, with variations of signal characteristics that may be varied more quickly being nested within variations of signal characteristics that may be varied more slowly.

For example, often a phase (as one of the signal characteristics) of the at least one test signal 91, 92 may be varied more quickly than a frequency (as another one of the signal characteristics). In that case, for the varying S02, a first frequency value would be set (first level of the nesting) while the phase would be varied, e.g. swept, between a lower threshold frequency value and an upper threshold phase value (second level of the nesting), then at least a second frequency value would be set while the phase would be swept again, and so on.

For example, based on a preset program code, or a request by a user, a phase, a frequency, a power (e.g. of the first test signal 91) and a power difference (between the first and the second test signals 91, 92) could be determined to be varied as signal characteristics of the two test signals 91, 92. In this case, a nesting hierarchy with four levels may be set or determined, wherein the frequency is at the first level, the power at the second level, the power difference at the third level and the phase variation at the fourth level.

In the generator unit 50 of the system 100 of Fig. 2, a different priority number for each of the signal characteristics that is variable by the signal generator unit 50 may be stored.

When more than one signal characteristic is selected from the list of the variable signal characteristics to determine which signal characteristic is, or which signal characteristics are, to be varied, the nesting hierarchy may be automatically determined by the generator unit 50 based on the priority numbers of the variable signal characteristics. Alternatively or additionally, the signal generator unit 50 may be configured to receive a user input signal, either via a mechanical interface or a data signal interface, of the signal generator unit 50, indicating a desired nesting hierarchy of the selected signal characteristics to be varied.

As a result, in particular as a direct result, of the at least one test signal 91, 92 being applied to the amplifying circuit 30, in particular to at least two input ports 31, 32, 33 of the amplifying circuit 30, at least one output signal 95 is output by the combining circuit 40 connected to the amplifying circuit 30. In particular, the output signal 95 may be output at the output port 41 of the combining circuit 40.

In a method step S03, at least one device characteristic of the device 10 is detected, based on the output signal 95, as a function of the at least one varied signal characteristic. In other words, the output signal 95 may be received, e.g. by a signal and spectrum analyzer, and on the received output signal 95, measurements may be performed to directly detect at least one device characteristic of the device 10. Alternatively, or additionally, the measurements may be evaluated, e.g. automatically by a calculating unit, to indirectly detect at least one device characteristic of the device 10.

The at least one device characteristic is preferably directly or indirectly related to a value of a passive electronic element of the input circuit to be calibrated, preferably to an adjustable value. The at least one device characteristic is preferably at least one of an efficiency, an adjacent channel leakage power ratio, ACLR, an output power, a linearity, and/or a peak envelope power of the device 10 under test.

Each combination of values of the at least one varied signal characteristic (or signal characteristics) on the one hand and the detected device characteristic (or device characteristics) may be stored as an individual data item in a database.

For example, four signal characteristics may be varied: a differential input phase (dPHs), a differential input amplitude (dAmp), an absolute input amplitude of a reference channel (pChA), e.g. the first test signal 91 or the second test signal 92, and a frequency (rFrq), e.g. of the first test signal 91 and/or of the second test signal 92. Then, three device characteristics may be determined as functions of said four signal characteristics: an efficiency, an adjacent channel leakage power ratio (ACLR), and an output power of the device 10 under test. In this example, the individual data items in the database may be 7-tuples, with four entries of each seven-tuple related to the four signal characteristics and three entries of each seven-tuple related to the three device characteristics.

In a method step S04, at least one optimizing value, or set of optimizing values, of the at least one signal characteristic is determined that optimizes at least one of the at least one device characteristic according to at least one criterion, for example a preset criterion. In other words, at least one target quantity may be selected out of the at least one device characteristics, the target quantity being the one that is to be optimized. The target quantity may e.g. be selected based on a user input or on a stored program code. For example, the target quantity may be an efficiency of the device 10. More than one target quantity may be selected, and, in particular, all of the device characteristics may be selected as target quantities.

It should be understood that, in particular when more than one signal characteristic is varied, a set of optimizing values may be determined, wherein the set of values comprises at least one optimizing value for each of the varied signal characteristics. In any case, more than one optimizing value may be determined for each of the varied signal characteristics. In particular, this may occur when more than one value of one varied signal characteristic results in the exact same value, or values, of the target quantity to be optimized.

Another case in which this may occur is when the optimization is characterized in that a certain threshold is set which the target quantity is to reach, whereas the exact value above said threshold that the target quantity reaches is irrelevant. For example, it may only be important that an efficiency (as an exemplary target quantity) of the amplifying circuit 30 and the combining circuit 40 is over 45% but not important whether the efficiency is 46% or 56%.

When more than one device characteristic is selected as target quantities, the optimizing may be performed according to a optimization hierarchy in which each of the target quantities is accorded a weight, and the optimization is performed in view of the respective weights of the target quantities.

For example, a first of the target quantities, called parameter A, may be accorded a weight of 90% and a second of the target quantities, called parameter B, may be accorded a weight of 10%. For instance, parameter A may be the efficiency and parameter B may be the output power. As an example, a situation could occur where a certain set C of values of the at least one signal characteristic would result in a 50% improvement, e.g. increase, of parameter B and in a 5% deterioration, e.g. decrease, of parameter A with respect to a reference set R of values for the at least one signal characteristic. In other words, the set C of values would increase the output power by 50% but reduce the efficiency by 5% relative to the reference set R of values. Then, taking into account the 90% weight of the first of the target quantities, a virtual 4.5% decrease of parameter A (90% weight of 5 % decrease) would be compared to a virtual 5% increase of parameter B (10% weight of 50% increase). Accordingly, said set C of values would still be chosen over the reference set R of values for the at least one signal characteristic, as 5% of virtual increase is larger than 4.5% of virtual decrease. Multiple virtual increases may be added, and/or multiple virtual decreases may be added, wherein the added virtual increases may then be compared to the added virtual decreases to determine the optimizing set of values.

The at least one preset criterion for the target quantity may be based on the at least one signal characteristic and/or the at least one device characteristic. The optimization according to the criterion may also comprise, or consist of, an optimization of one, or more, target quantities under boundary conditions given for one or more of the at least one signal characteristic and/or one or more of the at least one device characteristic.

For instance, the efficiency and the adjacent channel leakage power ratio (ACLR) of the device 10 under test may be selected as target quantities, under the boundary conditions that a) the frequency (as one test signal characteristic) is 960 MHz, that b) the efficiency is over 43% and that c) the adjacent channel leakage power ratio (ACLR) is smaller than -30 dBc, wherein the test signal characteristic to be optimized is the differential phase, or differential input phase, dPhs. In other words, an optimizing value of the differential phase will be searched for that fulfills the above boundary conditions.

A result signal 99 indicating the determined at least one optimizing value, or set of optimizing values, of the at least one signal characteristic may optionally be generated and e.g. transmitted to a display unit, or another unit of the system 100.

More than one optimization criterion may be employed successively. The result signal 99 may be generated configured to indicate a degree to which each of the successively employed optimization criteria is fulfilled by its respective optimization values.

Referring to Fig. 2, the determining S03 of the at least one device characteristic of the output signal 95 may be performed by a signal analyzing unit 60 of the system 100. As the signal analyzing unit 60 for example the "R&S®FSW Signal and Spectrum Analyzer" by Rohde&Schwarz may be used. The signal analyzing unit 60 may preferably be configured to perform the determining S03 of the at least one device characteristic in the same way as described in the foregoing and/or in the following with respect to the method according to the first aspect of the invention, in particular with respect to Fig. 1.

The determining S04 of the at least one value, or set of values, of the signal characteristic and the optional generating of the result signal 99 may be performed by a calculating unit 70 of the system 100. To this end, a data signal 96 from the signal analyzing unit 70 may be transmitted to the calculating unit 70, wherein the data signal 96 indicates the determined at least one device characteristic of the output signal 95, in particular as a function of the at least one varied test signal characteristic. The calculating unit may preferably be configured to perform the determining S04 of the at least one optimizing value of the signal characteristic and the optional generating of the result signal in the same way as described in the foregoing and/or in the following with respect to the method according to the first aspect of the invention, in particular with respect to Fig. 1.

Based on at least one optimizing value, or set of optimizing values, of the at least one signal characteristic, construction values of passive electronic elements of the input circuit to be calibrated may be derived. Such construction values may include one or more capacitances, one or more inductances, one or more electrical resistances and/or one or more impedances of elements of the input circuit. Usage of the derived construction values in realizing an input circuit then may result in a calibrated input circuit, as described in the following.

The signal generator unit 50 and the signal analyzing unit 60 are preferably time synchronized. The method of Fig. 1 may preferably comprise a method step of time synchronizing the signal generator unit 50 and the signal analyzing unit 60.

In a method step S05, the input circuit may be calibrated based on, exclusively or among other data, the determined optimizing value, or optimizing values, of the at least one test signal characteristic. In particular, the input circuit may be calibrated such as to provide the amplifying circuit with at least one input signal that has, or have, input signal characteristics that are equal, or as close as possible, to the determined optimizing value, or optimizing values, of the at least one test signal characteristic.

For example, the determining S04 may show that a frequency of the value F is an optimizing value. The input circuit may then be calibrated such as to provide the amplifying circuit with at least one input signal with a frequency of the value F.

The calibrating S05 may comprise, or consist of, adapting, preferably automatically adapting, properties of a pre-produced input circuit based on the determined optimizing values. Alternatively or additionally the calibrating S05 may comprise, or consist of, choosing one out of a set of pre-produced input circuits based on the determined optimizing values. For example one out of the set of pre-produced input circuits may be chosen, preferably automatically, such that the values of the passive electronic elements of said input circuit are the closest to the determined optimizing values.

In determining which of said set of pre-produced input circuits is to be chosen, a weighting of the values of the passive electronic elements may be taken into account, similarly to the weighting of the target quantities as described in the foregoing. For example, an input circuit D may be chosen over an input circuit E because the total sum of virtual increases in the values resulting from choosing input circuit D over input circuit E is larger than the total sum of virtual decreases in the values resulting from choosing input circuit D over input circuit E.

Alternatively or additionally, the calibrating S05 may comprise, or consist of, controlling a calibrating unit 80 to select or produce the input circuit based on the determined optimizing values.

Alternatively or additionally, the calibrating S05 may comprise, or consist of, creating a blueprint or schematics data based on the determined optimizing values, the blueprint or schematics data being adapted for use with a calibrating unit 80, wherein the calibrating unit 80 is enabled by the blueprint or schematics data to produce the input circuit 20.

Fig. 4 shows a schematic block diagram illustrating a system 100' for calibrating an input circuit for a device 10 under test comprising an amplifying circuit 30 and a combining circuit 40 according to another embodiment of the third aspect of the invention. The system 100' is a variant of the system 100 of Fig. 2 and may be modified and adapted according to any modifications and variations described with respect to the system 100. The system 100' differs from the system 100 in particular in that it comprises an additional calibrating unit 80 and an optional attenuator 38.

The calibrating unit 80 is adapted to receive the result signal 99 indicating the determined at least one optimizing value, or set of optimizing values, of the at least one signal characteristic. The calibrating unit 80 is further configured calibrate the input circuit 20, in particular as described in the foregoing or the following with respect to the method of Fig. 1.

The system 100' is also shown with an optional attenuator 38 connected between the combining circuit 30 and the signal analyzing unit 60 of the system 100'. The attenuator may also be connected between the combining circuit 30 and the signal analyzing unit 60 of the system 100 of Fig. 2.

Fig. 5 shows a schematic flow diagram illustrating a method for calibrating an input circuit for a device 10 under test including an amplifying circuit 30 and a combining circuit 40 according to another embodiment of the first aspect of the invention. In addition to the method steps of the method described with reference to Fig. 1, the method of Fig. 5 comprises the method step of connecting, S06, the calibrated input circuit to the device 10 to create an amplifier apparatus 101. The method of Fig. 5 including the method step S06 may also be termed a method for providing, or producing, an amplifier apparatus.

Fig. 6 shows a schematic block diagram of an amplifier apparatus 101 created by connecting a calibrated input circuit 20 to the device 10.

The architecture of the calibrated input circuit 20, the amplifying circuit 30 and the combining circuit 40 may be chosen such that the created amplifier apparatus 101 is configured with a Doherty amplifier architecture, a balanced amplifier architecture, an anti-phase amplifier architecture and/or a spatially combined amplifier architecture. Preferably, the amplifier apparatus 101 is configured as an active load modulation amplifier apparatus and/or as a millimeter wave amplifier apparatus, in particular a millimeter wave 5G power amplifier apparatus.

A non-volatile storage medium according to an embodiment of the second aspect of the present invention comprises a program code executable by a processor, the program code being adapted to perform, when executed, a method according to the first aspect of the present invention, in particular the method of Fig. 1, the method of Fig. 5, or any or all modification and variations described thereof. The non-volatile storage medium may be a CD-ROM, a flash drive, a floppy disk, and SD card and so on.

In the foregoing detailed description, various features are grouped together in one or more examples or examples with the purpose of streamlining the disclosure. It is to be understood that the above description is intended to be illustrative, and not restrictive. It is intended to cover all alternatives, modifications and equivalents. Many other examples will be apparent to one skilled in the art upon reviewing the above specification.

The embodiments were chosen and described in order to best explain the principles of the invention and its practical applications, to thereby enable others skilled in the art to best utilize the invention and various embodiments with various modifications as are suited to the particular use contemplated. In the appended claims and throughout the specification, the terms "including" and "in which" are used as the plain-English equivalents of the respective terms "comprising" and "wherein," respectively. Furthermore, "a" or "one" does not exclude a plurality.

## Claims

1. A method for calibrating an input circuit (20) for a device (10) under test, the device (10) including an amplifying circuit (30) and a combining circuit (40), the method comprising the steps of:
supplying (S01) at least one test signal (91, 92) to the amplifying circuit (30); wherein, as a result of the supplying (S01) of the test signal (91, 92) to the amplifying circuit (30), an output signal (95) is output by the combining circuit (40);
varying (S02) at least one test signal characteristic of the test signal (91, 92) supplied to the amplifying circuit (30);
detecting (S03), based on the output signal (95), at least one device characteristic of the device (10) as a function of the varied test signal characteristic;
determining (S04) at least one optimizing value of the test signal characteristic that optimizes at least one of the detected device characteristics according to at least one optimization criterion; and
calibrating (S05) the input circuit (20) based on the determined optimizing value of the test signal characteristic.

2. The method according to claim 1,
wherein the at least one signal characteristic of the at least one test signal (91, 92) is at least one of:
- a frequency,
- an absolute amplitude,
- a differential amplitude and/or
- a differential phase
of the at least one test signal (91, 92).

3. The method according to claim 1 or 2,
wherein the at least one device characteristic is at least one of:
- an efficiency,
- an adjacent channel leakage power ratio, ACLR
- an output power
- a linearity and/or
- a peak envelope power
of the device (10).

4. The method according to one or more of claims 1 to 3,
wherein the at least one criterion is based on the at least one test signal characteristic and/or the at least one device characteristic.

5. The method according to one or more of claims 1 to 4,
wherein the at least one test signal (91, 92) is provided by a signal generating unit (50);
wherein the device characteristic is detected by a signal analyzing unit (60); the method further comprising the step of:
synchronizing the signal generating unit (50) and the signal analyzing unit (60).

6. The method according to claim 5,
wherein the amplifying circuit (30) and/or the combining circuit (40) is connected to an internal and/or an external power source;
the method further comprising the step of:
synchronizing the internal and/or external power source with the signal generating unit (50) and/or with the signal analyzing unit (60).

7. The method according to one or more of claims 1 to 6,
wherein the calibrating (S05) of the input circuit (20) comprises at least one of:
- controlling a calibrating unit (80) to produce the input circuit (20) based on the determined optimizing values,
- adapting properties of an input circuit (20) based on the determined optimizing values,
- creating a blueprint or schematics data based on the determined optimizing values for a calibrating unit (80), based on which the calibrating unit (80) is able to produce the input circuit (20), and/or
- choosing one out of a set of pre-produced input circuits based on the determined optimizing values.

8. The method according to one or more of the claims 1 to 7,
comprising the step of:
connecting (S06) the calibrated input circuit (20) to the device (10) to create an amplifier apparatus (101).

9. The method according to claim 8,
wherein the amplifier apparatus (10) is configured with a Doherty amplifier architecture, a balanced amplifier architecture, an anti-phase amplifier architecture and/or a spatially combined amplifier architecture.

10. The method according to claim 8 or 9,
wherein the amplifier apparatus (101) is configured as an active load modulation amplifier apparatus.

11. Non-volatile storage medium, comprising a program code executable by a processor, the program code being adapted to perform, when executed, the method according to any of claims 1 to 10.

12. System (100) for providing an input circuit (20) for a device (10) under test, the device (10) including an amplifying circuit (30) and a combining circuit (40), comprising a signal generator unit (50), a signal analyzing unit (60), and a calculating unit (70);
wherein the signal generator unit (50) is configured to supply (S01) at least one test signal (91, 92) to the amplifying circuit (30), and to vary (S02) at least one test signal characteristic of the test signal (91, 92) supplied to the amplifying circuit (30);
wherein the signal analyzing unit (60) is configured to detect (S04), from an output signal (95) of the combining circuit (40), at least one device characteristic of the device (10) as a function of the at least one varied test signal characteristic; and
wherein the calculating unit (70) is further configured to determine (S05) at least one optimizing value of the test signal characteristic that optimizes at least one of the device characteristics according to at least one optimization criterion and to produce a result signal (99) indicating the determined at least one optimizing value of the signal characteristic.

13. System (100) according to claim 12,
comprising a power source connectable or connected to the amplifying circuit (30) and/or to the combining circuit (40),
wherein the power source is synchronized with the signal generator unit (50) and/or with the signal analyzing unit (60).

14. System (100) according to one or more of claims 11 to 13,
wherein an attenuator (38) is coupled between the combining circuit (40) and the signal analyzing unit (60).
